(19) **Europäisches Patentamt European Patent Office Office européen des brevets**

(11) **EP 4 162 610 B1**

(12) **FASCICULE DE BREVET EUROPEEN**

(45) Date de publication et mention de la délivrance du brevet:
**25.02.2026 Bulletin 2026/09**

(21) Numéro de dépôt: **21732203.1**

(22) Date de dépôt: **02.06.2021**

(51) Classification Internationale des Brevets (IPC):
**H03M 1/06** *(2006.01)* **H03M 1/12** *(2006.01)*
**H03M 1/66** *(2006.01)*

(52) Classification Coopérative des Brevets (CPC):
**H03M 1/0624;** H03M 1/12; H03M 1/66

(86) Numéro de dépôt international:
**PCT/EP2021/064823**

(87) Numéro de publication internationale:
**WO 2021/249848 (16.12.2021 Gazette 2021/50)**

(54) **PROCEDE DE SYNCHRONISATION DE CONVERTISSEURS DE TYPE ANALOGIQUE-NUMERIQUE OU NUMERIQUE-ANALOGIQUE, ET SYSTEME CORRESPONDANT**

VERFAHREN ZUR SYNCHRONISATION VON ANALOG-DIGITAL- ODER DIGITAL-ANALOG-WANDLERN UND ENTSPRECHENDES SYSTEM

METHOD FOR SYNCHRONISING ANALOGUE-TO-DIGITAL OR DIGITAL-TO-ANALOGUE CONVERTERS AND CORRESPONDING SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.06.2020 FR 2005986**

(43) Date de publication de la demande:
**12.04.2023 Bulletin 2023/15**

(73) Titulaire: **Teledyne E2V Semiconductors SAS 38120 Saint-Egrève (FR)**

(72) Inventeurs:
• **BERAUD-SUDREAU, Quentin**
  **38140 RIVES SUR FURE (FR)**
• **LIGOZAT, Jérôme**
  **38000 GRENOBLE (FR)**
• **STACKLER, Marc**
  **Shanghai Street Jordan Hong Kong (CN)**
• **LAUBE, Rémi**
  **38113 VEUREY-VOROIZE (FR)**

(74) Mandataire: **Atout PI Laplace Immeuble Up On 25 Boulevard Romain Rolland CS 40072 75685 Paris Cedex 14 (FR)**

(56) Documents cités:
**EP-A2- 2 658 129    US-A1- 2019 360 911**

• STACKLER MARC ET AL: "A novel method to synchronize high-speed data converters", 2016 IEEE RADAR CONFERENCE (RADARCONF), IEEE, 2 May 2016 (2016-05-02), pages 1 - 5, XP032909076, DOI: 10.1109/ RADAR.2016.7485292
• TORRES-GONZALEZ FELIPE ET AL: "Scalability analysis of the white-rabbit technology for cascade-chain networks", 2016 IEEE INTERNATIONAL SYMPOSIUM ON PRECISION CLOCK SYNCHRONIZATION FOR MEASUREMENT, CONTROL, AND COMMUNICATION (ISPCS), IEEE, 4 September 2016 (2016-09-04), pages 1 - 6, XP032971427, DOI: 10.1109/ISPCS.2016.7579515

**Description**

L'invention se rapporte à un procédé de synchronisation de convertisseurs de type analogique-numérique ou numérique-analogique. L'invention se rapporte aussi à un système de synchronisation de convertisseurs de type analogique-numérique ou numérique-analogique.

Certaines applications utilisant plusieurs convertisseurs analogique-numérique ou plusieurs convertisseurs numérique-analogique nécessitent de pouvoir synchroniser ces convertisseurs entre eux. Par synchronisation, on entend un alignement déterministe des données à convertir ou des données converties.

Cela peut concerner notamment les applications de modulation I/Q qui travaillent avec un convertisseur qui traite les signaux en phase (I), et un convertisseur qui traite les signaux en quadrature de phase (Q). Pour que la modulation soit efficace, il est nécessaire que les signaux soient en quadrature, au risque de dégrader les performances du modulateur.

D'autres applications requièrent l'emploi de plusieurs dizaines de convertisseurs synchrones. C'est notamment le cas des réseaux d'antennes, dédiés par exemple à la formation de faisceau. La formation de faisceau comprend plusieurs canaux, chacun équipé d'un convertisseur numérique-analogique. Là aussi, il est nécessaire que les différents convertisseurs aient un alignement contrôlé et déterministe, et ce même à des fréquences de travail élevées.

Dans le cas d'un convertisseur analogique-numérique, les mots numériques, résultant de la conversion, doivent être alignés pour correspondre entre eux pour un traitement numérique ultérieur. Dans le cas d'un convertisseur numérique-analogique, les signaux numériques en entrée doivent également être alignés et être traités au même moment par les convertisseurs.

Dans le cas d'un convertisseur analogique-numérique, les données peuvent être réalignées dans l'unité de commande (généralement FPGA ou ASIC). En revanche, dans le cas d'un convertisseur numérique-analogique, le seul moyen de réaligner les signaux en sortie est d'utiliser un retard analogique ; ce type de composant est très gourmand en énergie et difficile à régler. La problématique de la synchronisation des convertisseurs est surtout propre aux convertisseurs numérique-analogique, bien que l'invention s'applique également à la synchronisation de convertisseurs analogique-numérique.

Différentes solutions existent aujourd'hui pour synchroniser plusieurs convertisseurs entre eux.

Une solution consiste, pour les interfaces de type LVDS (« Low Voltage Differential Signaling », ou « transmission différentielle basse tension » : interface de raccordement entre les convertisseurs et les FPGA/ASIC), à ajuster la longueur de tous les chemins électriques afin de garantir la synchronisation de tous les convertisseurs dans la même période d'horloge. Les temps de propagation des signaux sur les pistes de cuivre d'une carte électronique étant de l'ordre de quelques ps/mm, il faut alors ajuster la longueur de tous les chemins électriques afin de garantir la synchronisation de tous les convertisseurs dans la même période d'horloge. Sur certaines applications, en particulier au-delà de la centaine de Mégahertz il est délicat, voire impossible, de jouer sur la distance physique séparant les composants. Cette solution est ainsi compliquée à mettre en œuvre et implique soit d'importantes contraintes sur les longueurs des pistes et/ou impactent l'horloge d'échantillonnage, ce qui dégrade les performances des convertisseurs.

Pour les interfaces série, pour lesquelles les données sont envoyées sans relation de phase entre elles, un mot est défini dans la trame, le mot est détecté, et les trames sont alignées entre elles. Afin d'aligner ces trames, une mémoire de taille importante (de l'ordre 1 kByte) est nécessaire, et la précision attendue n'est pas obtenue. Les solutions consistant à rajouter des composants sur le chemin du signal d'horloge sont susceptibles de faire fluctuer le signal d'horloge (phénomène de gigue ou « jitter » selon la terminologie anglo-saxonne), ce qui dégrade les performances de l'horloge.

En particulier, il existe des solutions qui utilisent des sous-divisions de la fréquence d'échantillonnage des convertisseurs et un format maître/esclave pour réaliser ces synchronisations. C'est le cas notamment de l'interface série JESD204B, décrite notamment dans le document « JESD204B Survival Guide » (disponible sous le lien https//www.analog.com/media/en/technical-documentation/technical-articles/JESD204B-Survival-Guide.pdf, page 21 et 22), qui assure l'interopérabilité des FPGA avec les convertisseurs analogique/numérique et avec les convertisseurs numérique/analogique. Cette solution est basée sur l'envoi aux convertisseurs d'une division de l'horloge très basse en fréquence aux convertisseurs ainsi qu'à l'unité de commande. Des composants actifs (« Fanout Buffer » et générateur d'horloge « AD9525 » dans le document précité), ajoutés sur le chemin du signal d'horloge, sont requis pour cette interface. Lors de la phase d'apprentissage de la synchronisation, il a été constaté que la tenue en température n'est pas bonne, en raison de la présence des composants actifs. Les variations en température rendent donc le système beaucoup plus difficile à régler, en particulier lorsqu'un réglage fin est requis.

Il est également connu, d'après le document EP 3 375 092 A1, de synchroniser des convertisseurs de données de proche en proche. Pour cela, les convertisseurs sont configurés en au moins une chaîne série. La distribution en phase d'un signal de synchronisation sur tous les convertisseurs est remplacée par la transmission du signal de synchronisation d'un convertisseur vers un autre pour atteindre de proche en proche tous les convertisseurs d'une chaîne. Lors d'une étape d'apprentissage, on détermine ainsi les délais de propagation (fixés par les caractéristiques physiques du chemin de propagation) d'un signal d'un point à un autre, pour chaque convertisseur.

D'après le document EP 3 375 092 A1, durant la phase d'apprentissage, l'utilisateur doit observer, par exemple à l'oscilloscope, le signal de synchronisation en sortie des convertisseurs consécutifs, qui correspond au délai de propagation entre la sortie d'un convertisseur et l'entrée du convertisseur suivant. Cette détermination est donc réalisée « manuellement » par l'utilisateur : elle n'est pas réalisée par un processus géré par l'unité de commande. Bien que la phase d'apprentissage n'ait lieu qu'une seule fois, le fait de devoir la gérer manuellement, avec des mesures faites par l'utilisateur, représente une perte de temps.

STACKLER MARC ET AL: "A novel method to synchronize high-speed data converters",2016 IEEE RADAR CONFERENCE (RADARCONF), IEEE, 2 mai 2016 (2016-05-02), pages 1-5, divulgue une approche en chaîne (daisy-chain) avec des fonctionnalités de détection et de correction de la métastabilité, afin de faciliter la synchronisation d'un grand nombre de convertisseurs de données.

EP 2 658 129 A2 concerne un système dans lequel les dispositifs sont synchronisés en réglant un compteur interne sur la base du décompte du temps qu'un échange de signaux entre les dispositifs prend;

US 2019/360911 A1 divulgue un système qui mesure un retard aller-retour d'un signal entre des unités de numérisation temporelle.

TORRES-GONZALEZ FELIPE ET AL: "Scalability analysis of the white-rabbit technology for cascade-chain networks",2016 IEEE INTERNATIONAL SYMPOSIUM ON PRECISION CLOCK SYNCHRONIZATION FOR MEASUREMENT, CONTROL, AND COMMUNICATION (ISPCS), IEEE, 4 septembre 2016, porte sur une technologie de White-Rabbit pour les réseaux en cascade, améliorant l'estimation des délais de transmission entre maître et esclave et vice versa, dans laquelle un port du dispositif WR est utilisé comme esclave pour se synchroniser avec le reste du réseau, et l'autre port agit en tant que maître de l'appareil suivant dans la chaîne.

L'invention vise donc à fournir un procédé de synchronisation de convertisseurs de type analogique-numérique ou numérique-analogique, et qui peut être réalisé automatiquement, sans l'intervention de l'utilisateur.

Un objet de l'invention est donc un procédé de synchronisation d'une pluralité de convertisseurs de type analogique-numérique ou numérique-analogique, les convertisseurs étant tous connectés à une unité de commande, ainsi qu'à une horloge ayant une période d'horloge prédéfinie, les convertisseurs étant par ailleurs chaînés de proche en proche de manière à former une chaîne de convertisseurs, chaque convertisseur générant un signal de synchronisation interne configuré pour fournir une référence temporelle à l'émission de données par le convertisseur, le procédé comprenant, pour chaque convertisseur, les étapes suivantes :

a) réception d'un signal de synchronisation transmis par l'unité de commande pour le premier convertisseur de la chaîne, ou transmis par le convertisseur précédent pour les autres convertisseurs de la chaîne, et transmission du signal de synchronisation à un convertisseur suivant sous forme d'un signal interne dit de sortie, ou à l'unité de commande pour le dernier convertisseur de la chaîne ;

b) réception, par le convertisseur suivant, du signal interne de sortie, et retransmission à destination du convertisseur du signal interne de sortie sous forme d'un signal interne dit de vérification, à l'exception du dernier convertisseur de la chaîne ;

c) réception du signal interne de vérification par le convertisseur, à l'exception du dernier convertisseur de la chaîne ;

d) détermination d'une latence entre le convertisseur et le convertisseur suivant, à l'exception du dernier convertisseur de la chaîne, par comptage, sur un même front actif d'horloge, des périodes d'horloge entre la transmission du signal interne de sortie et la réception du signal interne de vérification ;

e) calcul d'un décalage interne à appliquer au signal de synchronisation interne de chaque convertisseur, le décalage interne étant déterminé en fonction d'au moins une partie des latences déterminées.

Le décalage interne $\Delta_{CONV\_k}$ du convertisseur de rang k (k=1, ..., N-1), est calculé par la relation suivante, en partant de k=N-1 :

$$\Delta_{CONV\_k} = 1/2 * lat_{CONV\_k->CONV\_k+1} + \Delta_{CONV\_k+1}$$

Où $lat_{CONV\_k->CONV\_k+1}$ correspond à la latence entre le convertisseur de rang k et le convertisseur de rang k+1,

Et où

$$\Delta_{CONV\_N} = 0.$$

Avantageusement chaque convertisseur détecte une métastabilité du signal interne de vérification, la métastabilité correspondant à une simultanéité du signal interne de vérification avec un front d'horloge actif, et transmet à l'unité de commande un signal indiquant la métastabilité ou non du signal interne de vérification, l'unité de commande transmettant alors, en cas de métastabilité du signal interne de vérification, un nouveau signal de synchronisation au premier convertisseur de la chaîne.

Avantageusement, le signal indiquant la métastabilité ou non du signal interne de vérification est transmis à l'unité de commande sur un bus de données série synchrone.

Avantageusement, chaque convertisseur transmet à l'unité de commande le décalage interne déterminé.

Avantageusement, le décalage interne déterminé est transmis à l'unité de commande.

Avantageusement, le signal de synchronisation transmis par l'unité de commande est une impulsion d'une durée au moins égale à une période d'horloge.

L'invention se rapporte également à un procédé de conversion synchrone d'une pluralité de signaux transmis par une unité de commande respectivement à une pluralité de convertisseurs de type analogique-numérique ou numérique-analogique, caractérisé en ce que le procédé de conversion met en œuvre au préalable le procédé de synchronisation précité.

L'invention se rapporte également à un système de synchronisation d'une pluralité de convertisseurs de type analogique-numérique ou numérique-analogique, les convertisseurs étant tous connectés à une unité de commande, ainsi qu'à une horloge ayant une période d'horloge prédéfinie, les convertisseurs étant par ailleurs chaînés de proche en proche de manière à former une chaîne de convertisseurs, chaque convertisseur étant configuré pour générer un signal de synchronisation interne de façon à fournir une référence temporelle à l'émission de données par le convertisseur, chaque convertisseur comprenant :

- un premier module configuré pour recevoir un signal de synchronisation transmis par l'unité de commande pour le premier convertisseur de la chaîne, ou transmis par le convertisseur précédent pour les autres convertisseurs de la chaîne, et pour transmettre le signal de synchronisation à un convertisseur suivant sous forme d'un signal interne dit de sortie, ou à l'unité de commande pour le dernier convertisseur de la chaîne ;
- un deuxième module configuré pour recevoir de façon synchrone, à l'exception du dernier convertisseur de la chaîne, le signal de sortie retransmis par le convertisseur suivant sous forme d'un signal interne dit de vérification ;
- un troisième module configuré pour déterminer une latence entre le convertisseur et le convertisseur suivant, par comptage, sur un même front actif d'horloge, des périodes d'horloge entre la transmission du signal interne de sortie et la réception du signal interne de vérification ;

l'unité de commande étant en outre configurée pour calculer un décalage interne à appliquer au signal de synchronisation interne de chaque convertisseur, le décalage interne étant déterminé en fonction d'au moins une partie des latences déterminées.

L'unité de commande est configurée pour calculer le décalage interne $\Delta_{CONV\_k}$ du convertisseur de rang k (k=1, ..., N-1), par la relation suivante, en partant de k=N-1 :

$$\Delta_{CONV\_k} = 1/2 * lat_{CONV\_k \to CONV\_k+1} + \Delta_{CONV\_k+1}$$

Où $lat_{CONV\_k \to CONV-k+1}$ correspond à la latence entre le convertisseur de rang k et le convertisseur de rang k+1,

Et où

$$\Delta_{CONV\_N} = 0$$

D'autres caractéristiques, détails et avantages de l'invention ressortiront à la lecture de la description faite en référence aux dessins annexés donnés à titre d'exemple et qui représentent, respectivement :

La figure 1 représente un organigramme du procédé de synchronisation selon l'invention ;
La figure 2 représente une chaîne de convertisseurs pour mettre en œuvre le procédé de synchronisation selon l'invention ;

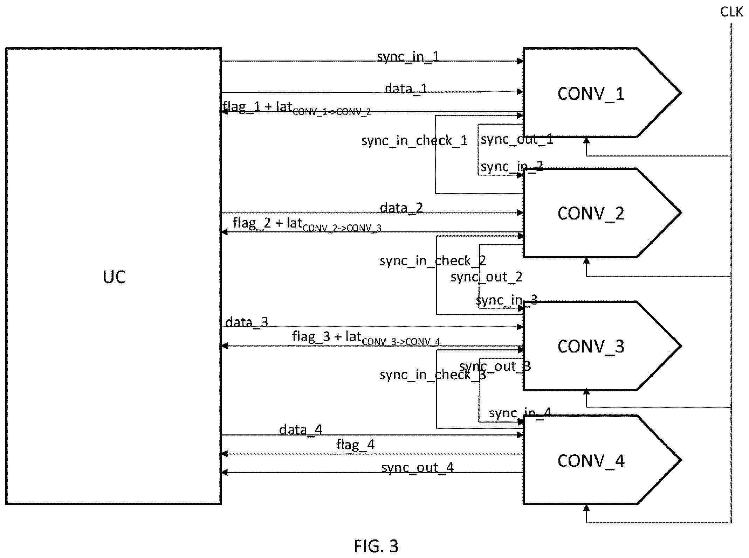

La figure 3 représente un exemple de chaîne de quatre convertisseurs pour mettre en œuvre le procédé de synchronisation selon l'invention ;
La figure 4 représente des chronogrammes des différents signaux utilisés dans l'exemple de la figure 3.
La figure 5 représente une vue en détail de chaque convertisseur, pour mettre en œuvre le procédé de synchronisation selon l'invention.

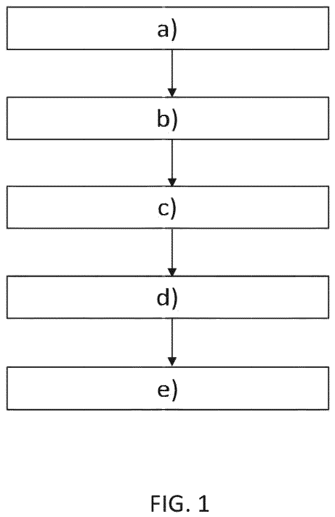

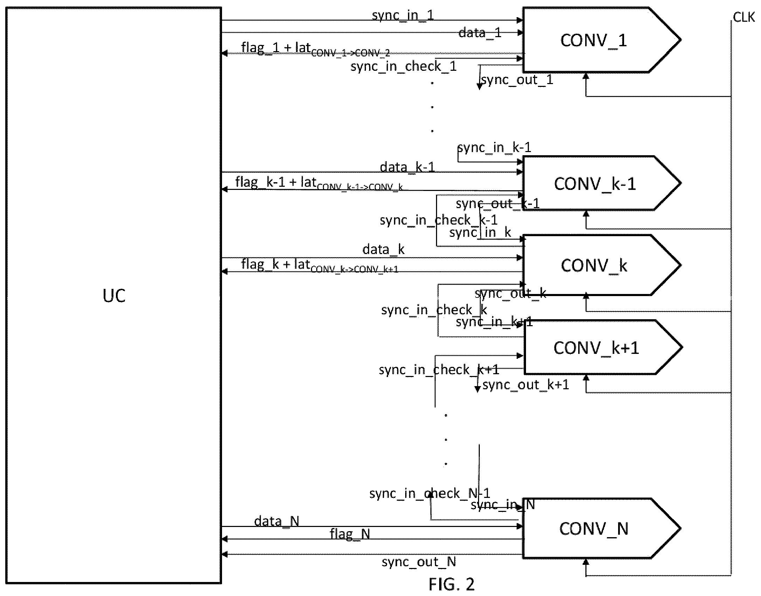

La figure 1 représente un organigramme du procédé de synchronisation selon l'invention, et la figure 2 représente une chaîne de convertisseurs ainsi que les différents signaux utilisés dans le cadre de l'invention. Les deux figures seront donc décrites simultanément.

Sur la figure 2, N convertisseurs sont représentés (N entier supérieur ou égal à 2), avec la convention suivante : le convertisseur CONV_k correspond au convertisseur de rang k du chaînage de proche en proche, avec k = 1, ..., N. Le convertisseur CONV_k, de rang k, reçoit un signal à convertir data_k transmis par l'unité de commande UC. Ainsi, N signaux à convertir sont transmis par l'unité de commande UC aux différents convertisseurs de la chaîne.

Par ailleurs, chaque convertisseur CONV_k, de rang k, est équipé d'une borne pour recevoir un signal de synchronisation sync_in_k, transmis soit par l'unité de commande s'agissant du premier convertisseur de la chaîne CONV_1, soit transmis par le convertisseur précédent CONV_k-1 pour les autres convertisseurs de la chaîne.

Le principe du chaînage de proche en proche des convertisseurs est le suivant : chaque convertisseur CONV_k, de rang k, reçoit le signal de synchronisation sync_in_k, et transmet le signal de synchronisation au convertisseur suivant CONV_k+1 (de rang k+1) sous forme d'un signal interne dit de sortie sync_out_k (étape a) du procédé, illustré schématiquement par la figure 1). La transmission du signal interne de sortie s'effectue de façon synchrone, sur un front actif du signal d'horloge CLK.

Le dernier convertisseur CONV_N de la chaîne transmet, quant à lui, le signal interne de sortie sync_out_N à l'unité de commande UC, ce qui permet d'informer l'unité de commande UC que le signal de synchronisation a transité via tous les convertisseurs de la chaîne.

Le principe du chaînage de convertisseurs de proche en proche est décrit dans le document EP 3 375 092 A1, en particulier à la figure 1 du document cité ; le fonctionnement complet de la chaîne de convertisseurs n'est donc pas décrit plus en détail dans la présente demande.

Le chaînage de proche en proche des convertisseurs permet de bien synchroniser les convertisseurs, au prix d'une étape d'apprentissage de paramètres de configuration de la synchronisation. Tous les délais de propagation du signal de synchronisation dans la chaine sont déterministes, les signaux de synchronisation en sortie des convertisseurs étant tous synchronisés sur un front actif d'horloge CLK.

Par ailleurs, une fois que le convertisseur suivant CONV_k+1, de rang k+1, a reçu le signal interne de sortie, (sync_out_k transmis par le convertisseur suivant CONV_k de rang k), celui-ci retransmet en retour, au convertisseur CONV_k de rang k, le signal interne de sortie sync_out_k sous forme d'un signal interne dit de vérification sync_in_check_k.

Chaque convertisseur réémet donc le signal interne de vérification sync_in_check_k à son prédécesseur à l'image du signal de synchronisation reçu sync_in_k+1 (étape b) du procédé selon l'invention). La transmission du signal interne de vérification s'effectue de façon synchrone, sur un front actif du signal d'horloge CLK. Le chemin suivi par le signal interne de vérification sync_in_check_k doit donc être identique (même longueur physique, mais pas nécessairement la même piste) au chemin du signal de synchronisation sync_in_k+1.

La transmission du signal interne de vérification et la transmission du signal interne de sortie ont lieu sur un front d'horloge de même nature (montant ou descendant).

A l'étape c) du procédé, le convertisseur CONV_k, de rang k, reçoit le signal interne de vérification sync_in_check_k qui avait été retransmis par le convertisseur suivant CONV_k+1, de rang k+1, à l'étape b).

Chaque convertisseur mesure ensuite (étape d)) la latence $lat_{CONV\_k->CONV\_k+1}$, entre lui et le convertisseur suivant. Pour cela, il compte les périodes d'horloge entre la transmission du signal interne de sortie sync_out_k et la réception du signal interne de vérification sync_in_check_k. La latence correspond ainsi au temps que met le signal pour être transmis au convertisseur suivant et pour revenir.

Chaque convertisseur (à l'exception du dernier de la chaîne) transmet à l'unité de commande UC la latence ainsi déterminée.

Enfin, l'unité de commande calcule un décalage interne $\Delta_{CONV\_k}$ à appliquer par chaque convertisseur au signal de synchronisation interne (Internal_Sync), lors de la phase de synchronisation. Le signal de synchronisation interne (Internal_Sync) est généré par chaque convertisseur (CONV_k) lors de la phase de synchronisation, afin de fournir une référence temporelle à l'émission de données par le convertisseur. Dans le procédé selon l'invention, le décalage interne est déterminé en fonction d'au moins une partie des latences déterminées.

Pour le convertisseur CONV_N situé en fin de chaîne, aucune latence n'est mesurée, car ce convertisseur sert de référence pour le décalage interne appliqué au signal de synchronisation interne.

Ainsi, les convertisseurs sont synchronisés lors de la phase de synchronisation, bien que les diviseurs d'horloges des différents convertisseurs soient initialement dans des états différents. Les données à convertir sont ensuite automatiquement alignées grâce au protocole de lien série qui s'aligne sur le signal de synchronisation interne.

La mesure de la latence entre chaque convertisseur et le suivant dans la chaîne peut être effectuée automatiquement. De même, le décalage interne, déterminé en fonction des latences déterminées, ne nécessite pas l'intervention d'un utilisateur.

Ainsi, cette procédure de synchronisation des convertisseurs peut être effectuée automatiquement.

Pour chaque convertisseur CONV_k de rang k, un premier étage de détection de métastabilité pour le signal de synchronisation sync_in_k permet, le cas échéant, de modifier le front (montant ou descendant) de l'horloge d'échantillonnage. Un tel étage de détection est décrit dans le document EP 3 375 092 A1 (circuit LS3 dans le document cité).

Par ailleurs, chaque convertisseur CONV_k de rang k comprend un deuxième étage de détection de métastabilité pour le signal interne de vérification sync_in_check_k. Si le convertisseur CONV_k de rang détecte une métastabilité du signal interne de vérification sync_in_check_k, il transmet à l'unité de commande UC un signal flag_k indiquant la métastabilité du signal interne de vérification sync_in_check_k.

Avantageusement, le signal flag_k indiquant la métastabilité ou non du signal interne de vérification sync_in_check_k est transmis à l'unité de commande UC. Un bus de données série synchrone SPI peut par exemple être utilisé pour transmettre la latence calculée par chaque convertisseur.

Par métastabilité du signal de synchronisation sync_in_k ou du signal interne de vérification sync_in_check_k, on entend une concomitance du front du signal en question avec le front d'horloge CLK prédéfini pour la détection (montant ou descendant).

Tant qu'une métastabilité est présente sur l'une des entrées du signal de synchronisation sync_in_k ou du signal interne de vérification sync_in_check_k, le système est non déterministe et il n'est pas possible de synchroniser correctement les différents convertisseurs, d'où l'intérêt d'avoir un indicateur pour le savoir et effectuer des réglages.

L'indicateur est avantageusement un bit drapeau (ou « flag » selon la terminologie anglo-saxonne), situé dans un registre de l'unité de commande UC. Le bit drapeau peut prendre une valeur prédéfinie pour indiquer qu'il n'y a pas métastabilité (par exemple le bit=0), et une autre valeur pour indiquer que métastabilité a été détectée (par exemple le bit=1).

Dans le cas où une métastabilité du signal interne de vérification sync_in_check_k ou du signal de synchronisation sync_in_k a été détectée, l'unité de commande UC transmet un nouveau signal de synchronisation sync_in_1 au premier convertisseur de la chaîne CONV_1. La procédure se reboucle tant qu'une métastabilité est détectée dans un des convertisseurs de la chaîne.

Les délais de propagation étant déterministes, ces réglages seront fixes à chaque mise sous tension des convertisseurs.

Le décalage interne $\Delta_{CONV\_k}$ du convertisseur de rang k (k=1, ..., N-1), est calculé par la relation suivante :

$$\Delta_{CONV\_k} = 1/2 * \text{lat}_{CONV\_k->CONV\_k+1} + \Delta_{CONV\_k+1}$$

Où $\text{lat}_{CONV\_k->CONV\_k+1}$ correspond à la latence entre le convertisseur de rang k et le convertisseur de rang k+1,

Et où

$$\Delta_{CONV\_N} = 0.$$

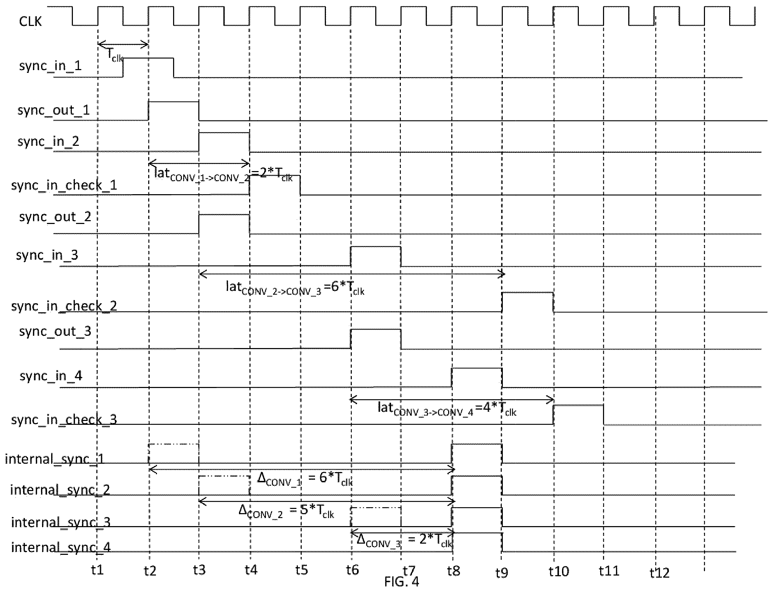

Un exemple de calcul du décalage interne est illustré par le chronogramme de la figure 4, qui doit être lu en lien avec l'agencement de quatre convertisseurs (CONV_1, CONV_2, CONV_3 et CONV_4) de la figure 4.

Par convention, sur la figure 4, tous les événements synchrones sont détectés sur un front montant de l'horloge CLK. En variante, les événements synchrones pourraient être détectés sur un front descendant de l'horloge CLK.

Le signal de synchronisation sync_in_1, transmis par l'unité de commande UC, est asynchrone : la réception du signal de synchronisation sync_in_1 par le convertisseur de rang 1 CONV_1 survient en-dehors d'un front d'horloge. Si le signal de synchronisation sync_in_1 était reçu concomitamment à un front d'horloge, le premier convertisseur CONV_1 transmettrait l'information de métastabilité à l'unité de commande UC afin de réémettre le signal de synchronisation sync_in_1.

Le convertisseur de rang 1 CONV_1 retransmet le signal de signal de synchronisation sync_in_1 sous forme d'un signal interne de sortie sync_out_1, sur le front actif suivant la réception asynchrone du signal de synchronisation sync_in_1 (instant t2). Le convertisseur CONV_2 de rang 2 reçoit, à l'instant t2, le signal de synchronisation sync_in_2 transmis par le convertisseur de rang 1 CONV_1. Le convertisseur CONV_2 de rang 2 renvoie au convertisseur de rang 1 CONV_1 le signal interne de vérification sync_in_check_1, reçu par le convertisseur de rang 1 CONV_1 à l'instant t4.

Le convertisseur de rang 1 CONV_1 compte deux périodes d'horloges entre les instants t2 et t4. Ainsi, la latence $\text{lat}_{CONV\_1->CONV\_2}$ entre le convertisseur de rang 1 et celui de rang 2 vaut $2*T_{clk}$.

De la même manière, il est déterminé que la latence $\text{lat}_{CONV\_2->CONV\_3}$ entre le convertisseur de rang 2 et celui de rang 3 vaut $6*T_{clk}$, et que la latence $\text{lat}_{CONV\_3->CONV\_4}$ entre le convertisseur de rang 3 et celui de rang 4 vaut $4*T_{clk}$.

Ainsi, le décalage interne $\Delta_{CONV\_4}$ du convertisseur de rang 4 vaut 0, le décalage interne $\Delta_{CONV\_3}$ du convertisseur de rang 3 vaut $4*T_{clk}/2 = 2*T_{clk}$. Le décalage interne $\Delta_{CONV\_2}$ du convertisseur de rang 2 vaut $6*T_{clk}/2 + 2*T_{clk} = 5*T_{clk}$. Le décalage interne $\Delta_{CONV\_1}$ du convertisseur de rang 1 vaut $2*T_{clk}/2 + 5*T_{clk} = 6*T_{clk}$.

Les décalages internes ainsi déterminés ($\Delta_{CONV\_1}$, $\Delta_{CONV\_2}$ et $\Delta_{CONV\_3}$), appliqués à chaque convertisseur correspondant, sont ensuite appliqués au signal de synchronisation interne (internal_sync) lors de la phase de synchronisation.

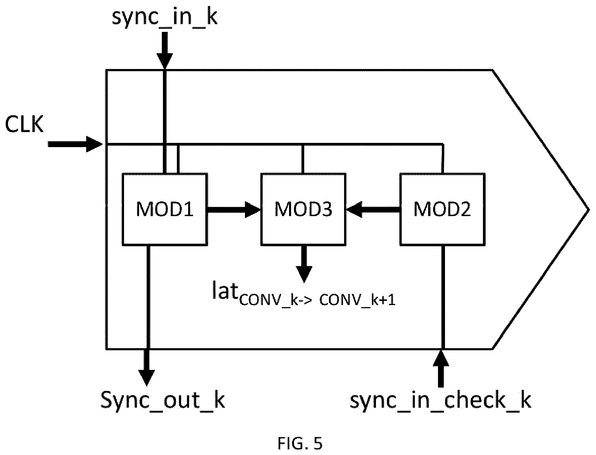

La figure 5 illustre le chronogramme de chaque signal de synchronisation interne (internal_sync_1, ..., 4) généré par chaque convertisseur lors de la phase de synchronisation. L'impulsion en pointillé représente le signal de synchronisation interne sans les décalages internes. En mettant en œuvre le procédé selon l'invention, les signaux de synchronisation interne (internal_sync_1, ..., 4) sont bien alignés entre eux pour tous les convertisseurs.

La figure 5 représente un convertisseur du système de synchronisation selon l'invention. Chaque convertisseur comprend un premier module MOD1, un deuxième module MOD2 et un troisième module MOD3.

Les trois modules sont connectés à l'horloge CLK.

Le premier module MOD1 reçoit le signal de synchronisation sync_in_k transmis par l'unité de commande UC pour le premier convertisseur CONV_1 de la chaîne, ou transmis par le convertisseur précédent (CONV_k-1) pour les autres convertisseurs de la chaîne. Il transmet également le signal interne de sortie sync_out_k au convertisseur suivant, ou à l'unité de commande UC pour le dernier convertisseur de la chaîne CONV_N.

Le deuxième module MOD2 reçoit le signal interne de vérification sync_in_check_k.

Le troisième module M3 détermine la latence $lat_{CONV\_k->\ CONV\_k+1}$ entre le convertisseur CONV_k et le convertisseur suivant CONV_k+1.

Chacun des modules (M1, M2, M3) peut comprendre des circuits de logique séquentielle et combinatoire afin de réaliser les fonctions précitées.

## Revendications

1. Procédé de synchronisation d'une pluralité de convertisseurs (CONV_k) de type analogique-numérique ou numérique-analogique, les convertisseurs (CONV_k) étant tous connectés à une unité de commande (UC), ainsi qu'à une horloge (CLK) ayant une période d'horloge prédéfinie ($T_{clk}$), les convertisseurs étant par ailleurs chaînés de proche en proche de manière à former une chaîne de convertisseurs, chaque convertisseur (CONV_k) générant un signal de synchronisation interne (internal_sync_k) configuré pour fournir une référence temporelle à l'émission de données par le convertisseur (CONV_k), le procédé comprenant, pour chaque convertisseur (CONV_k), les étapes suivantes :

   a) réception d'un signal de synchronisation (sync_in_k) transmis par l'unité de commande (UC) pour le premier convertisseur (CONV_1) de la chaîne, ou transmis par le convertisseur précédent (CONV_k-1) pour les autres convertisseurs de la chaîne, et transmission du signal de synchronisation à un convertisseur suivant (CONV_k+1) sous forme d'un signal interne dit de sortie (sync_out_k), ou à l'unité de commande (UC) pour le dernier convertisseur (CONV_N) de la chaîne;

   **caractérisé en ce que** le procédé comprend en outre les étapes suivantes:

   b) réception, par le convertisseur suivant (CONV_k+1), du signal interne de sortie (sync_out_k), et retransmission à destination du convertisseur (CONV_k) du signal interne de sortie (sync_out k) sous forme d'un signal interne dit de vérification (sync_in_check k), à l'exception du dernier convertisseur de la chaîne (CONV_N) ;

   c) réception du signal interne de vérification (sync_in_check_k) par le convertisseur (CONV_k), à l'exception du dernier convertisseur de la chaîne (CONV_N) ;

   d) détermination d'une latence ($lat_{CONV\_k->CONV}$ k+1) entre le convertisseur et le convertisseur suivant, à l'exception du dernier convertisseur (CONV_N) de la chaîne, par comptage, sur un même front actif d'horloge, des périodes d'horloge entre la transmission du signal interne de sortie (sync_out_k) et la réception du signal interne de vérification (sync_in_check_k) ;

   e) calcul d'un décalage interne ($\Delta_{CONV\,k}$) à appliquer au signal de synchronisation interne (internal_sync_k) de chaque convertisseur (CONV_k), le décalage interne étant déterminé en fonction d'au moins une partie des latences déterminées,

   dans lequel le décalage interne $\Delta_{CONV\,k}$ du convertisseur de rang k (k=1, ..., N-1), est calculé par la relation suivante, en partant de k=N-1 :

$$\Delta_{CONV\_k} = 1/2 * lat_{CONV\_k->CONV\_k+1} + \Delta_{CONV\_k+1}$$

   Où $lat_{CONV\,k->CONV\,k+1}$ correspond à la latence entre le convertisseur de rang k et le convertisseur de rang k+1, Et où

$$\Delta_{\text{CONV\_N}} = 0.$$

**2.** Procédé selon la revendication 1, dans lequel chaque convertisseur détecte une métastabilité du signal interne de vérification (sync_in_check_k), la métastabilité correspondant à une simultanéité du signal interne de vérification (sync_in_check_k) avec un front d'horloge actif, et transmet à l'unité de commande (UC) un signal (flag_k) indiquant la métastabilité ou non du signal interne de vérification (sync_in_check_k), l'unité de commande (UC) transmettant alors, en cas de métastabilité du signal interne de vérification (sync_in_check_k), un nouveau signal de synchronisation (sync_in_k) au premier convertisseur de la chaîne (CONV_1).

**3.** Procédé selon la revendication 2, dans lequel le signal (flag_k) indiquant la métastabilité ou non du signal interne de vérification (sync_in_check_k) est transmis à l'unité de commande sur un bus de données série synchrone (SPI).

**4.** Procédé selon l'une des revendications précédentes, dans lequel chaque convertisseur (CONV_k) transmet à l'unité de commande (UC) le décalage interne déterminé ($\Delta_{\text{CONV\_k}}$).

**5.** Procédé selon les revendications 3 et 4, dans lequel le décalage interne déterminé ($\Delta_{\text{CONV\_k}}$) est transmis à l'unité de commande (UC).

**6.** Procédé selon l'une des revendications précédentes, dans lequel le signal de synchronisation (sync_in_k) transmis par l'unité de commande est une impulsion d'une durée au moins égale à une période d'horloge.

**7.** Procédé de conversion synchrone d'une pluralité de signaux (DATA_k) transmis par une unité de commande (UC) respectivement à une pluralité de convertisseurs (CONV_k) de type analogique-numérique ou numérique-analogique, **caractérisé en ce que** le procédé de conversion met en œuvre au préalable le procédé de synchronisation selon l'une des revendications précédentes.

**8.** Système de synchronisation d'une pluralité de convertisseurs (CONV_k) de type analogique-numérique ou numérique-analogique, les convertisseurs (CONV_k) étant tous connectés à une unité de commande (UC), ainsi qu'à une horloge (CLK) ayant une période d'horloge prédéfinie ($T_{clk}$), les convertisseurs (CONV_k) étant par ailleurs chaînés de proche en proche de manière à former une chaîne de convertisseurs, chaque convertisseur (CONV_k) étant configuré pour générer un signal de synchronisation interne (internal_sync_k) de façon à fournir une référence temporelle à l'émission de données par le convertisseur (CONV_k), chaque convertisseur (CONV_k) comprenant :

- un premier module (MOD1) configuré pour recevoir un signal de synchronisation (sync_in_k) transmis par l'unité de commande (UC) pour le premier convertisseur (CONV_1) de la chaîne, ou transmis par le convertisseur précédent (CONV_k-1) pour les autres convertisseurs de la chaîne, et pour transmettre le signal de synchronisation à un convertisseur suivant sous forme d'un signal interne dit de sortie (sync_out_k), ou à l'unité de commande (UC) pour le dernier convertisseur de la chaîne (CONV_N) ;
- un deuxième module (MOD2) configuré pour recevoir de façon synchrone, à l'exception du dernier convertisseur (CONV_N) de la chaîne, le signal de sortie retransmis par le convertisseur suivant sous forme d'un signal interne dit de vérification (sync_in_check_k) ;
- un troisième module (MOD3) configuré pour déterminer une latence ($\text{lat}_{\text{CONV\_k-> CONV\_k+1}}$) entre le convertisseur (CONV_k) et le convertisseur suivant (CONV_k+1), par comptage, sur un même front actif d'horloge, des périodes d'horloge entre la transmission du signal interne de sortie (sync_out_k) et la réception du signal interne de vérification (sync_in_check_k) ;

l'unité de commande (UC) étant en outre configurée pour calculer un décalage interne ($\Delta_{\text{CONV\_k}}$) à appliquer au signal de synchronisation interne (internal_sync_k) de chaque convertisseur (CONV_k), le décalage interne ($\Delta_{\text{CONV\_k}}$) étant déterminé en fonction d'au moins une partie des latences déterminées,

dans lequel l'unité de commande (UC) est configurée pour calculer le décalage interne $\Delta_{\text{CONV\_k}}$ du convertisseur de rang k (k=1, ..., N-1), par la relation suivante, en partant de k=N-1 :

$$\Delta_{\text{CONV\_k}} = 1/2 * \text{lat}_{\text{CONV\_k->CONV\_k+1}} + \Delta_{\text{CONV\_k+1}}$$

Où $\text{lat}_{\text{CONV\_k->CONV\_k+1}}$ correspond à la latence entre le convertisseur de rang k et le convertisseur de rang k+1,

Et où $\Delta_{\text{CONV\_N}} = 0$

**EP 4 162 610 B1**

**Patentansprüche**

1. Verfahren zur Synchronisierung einer Vielzahl von Analog-Digital- oder Digital-Analog-Wandlern (CONV_k), wobei die Wandler (CONV_k) alle mit einer Steuereinheit (UC) sowie mit einem Taktgeber (CLK) mit einer vordefinierten Taktperiode ($T_{clk}$) verbunden sind, wobei die Wandler außerdem nacheinander zu einer Wandlerkette verkettet sind, wobei jeder Wandler (CONV_k) ein internes Synchronisationssignal (internal_sync_k) erzeugt, das so konfiguriert ist, dass es eine Zeitreferenz für die Datenübertragung durch den Wandler (CONV_k) bereitstellt, wobei das Verfahren für jeden Wandler (CONV_k) die folgenden Schritte umfasst:

   a) Empfangen eines Synchronisationssignals (sync_in_k), das von der Steuereinheit (UC) für den ersten Wandler (CONV_1) der Kette oder vom vorhergehenden Wandler (CONV_k-1) für die anderen Wandler der Kette übertragen wird, und Übertragen des Synchronisationssignals an einen nachfolgenden Wandler (CONV_k+1) in Form eines sogenannten internen Ausgangssignals (sync_out_k) oder an die Steuereinheit (UC) für den letzten Wandler (CONV_N) der Kette;

   **dadurch gekennzeichnet, dass** das Verfahren weiter die folgenden Schritte umfasst:

   b) Empfangen des internen Ausgangssignals (sync_out_k) durch den nachfolgenden Wandler (CONV_k+1) und Weiterleiten des internen Ausgangssignals (sync_out_k) in Form eines sogenannten internen Verifizierungssignals (sync_in_check_k) an den Wandler (CONV_k), abgesehen vom letzten Wandler (CONV_k) der Kette;
   c) Empfangen des internen Verifizierungssignals (Sync in check k) durch den Wandler (CONV_k), abgesehen vom letzten Wandler der Kette (CONV_N);
   d) Bestimmen einer Latenz (($lat_{CONV\_K->CONV}$_k+1) zwischen dem Wandler und dem nachfolgenden Wandler, abgesehen vom letzten Wandler (CONV_N) der Kette, durch Zählen der Taktperioden zwischen der Übertragung des internen Ausgangssignals (sync_out_k) und dem Empfang des internen Verifizierungssignals (sync_in_check_k) auf derselben aktiven Taktflanke;
   e) Berechnen einer internen Verschiebung ($\Delta_{CONV\ k}$), die auf das interne Synchronisationssignal (internal_sync_k) jedes Wandlers (CONV_k) anzuwenden ist, wobei die interne Verschiebung in Abhängigkeit von mindestens einem Teil der bestimmten Latenzen bestimmt wird, wobei die interne Verschiebung $\Delta_{CONV\ k}$ des Wandlers der Rangstufe k (k=1, ..., N-1) gemäß der folgenden Gleichung berechnet wird, beginnend mit k=N-1:

$$\Delta_{CONV\_k} = 1/2 * lat_{CONV\_k->CONV\_k+1} + \Delta_{CONV-k+1}$$

   worin $lat_{CONV\_k->conv\_k+1}$ der Latenz zwischen dem Wandler der Rangstufe k und dem Wandler der Rangstufe k+1 entspricht,
   und worin

$$\Delta_{CONV\_N=0.}$$

2. Verfahren nach Anspruch 1, wobei jeder Wandler eine Metastabilität des internen Verifizierungssignals (sync_in_check_k) erfasst, wobei die Metastabilität einer Gleichzeitigkeit des internen Verifizierungssignals (sync_in_check_k) mit einer aktiven Taktflanke entspricht, und ein Signal (flag_k) an die Steuereinheit (UC) überträgt, das angibt, ob das interne Verifizierungssignal (sync_in_check_k) eine Metastabilität aufweist oder nicht, wobei die Steuereinheit (UC) im Falle einer Metastabilität des internen Verifizierungssignals (sync_in_check_k) ein neues Synchronisierungssignal (sync_in_k) an den ersten Wandler der Kette (CONV_1) überträgt.

3. Verfahren nach Anspruch 2, wobei das Signal (flag_k), das angibt, ob das interne Prüfsignal (sync_in_check_k) eine Metastabilität aufweist oder nicht, über einen synchronen seriellen Datenbus (SPI) an die Steuereinheit übertragen wird.

4. Verfahren nach einem der vorstehenden Ansprüche, wobei jeder Wandler (CONV_k) die bestimmte interne Verschiebung ($\Delta_{CONV\_K}$) an die Steuereinheit (UC) überträgt.

5. Verfahren nach einem der Ansprüche 3 und 4, wobei die bestimmte interne Verschiebung ($\Delta_{CONV\_k}$) an die Steuereinheit (UC) übertragen wird.

9

6. Verfahren nach einem der vorstehenden Ansprüche, wobei das von der Steuereinheit übertragene Synchronisierungssignal (sync_in_k) ein Impuls mit einer Dauer von mindestens einer Taktperiode ist.

7. Verfahren zur synchronen Umwandlung einer Vielzahl von Signalen (DATA_k), die von einer Steuereinheit (UC) jeweils an eine Vielzahl von Analog-Digital- oder Digital-Analog-Wandlern (CONV_k) übertragen werden, **dadurch gekennzeichnet, dass** das Umwandlungsverfahren zuvor das Synchronisierungsverfahren gemäß einem der vorstehenden Ansprüche durchführt.

8. System zur Synchronisierung einer Vielzahl von Analog-Digital- oder Digital-Analog-Wandlern (CONV_k), wobei die Wandler (CONV_k) alle mit einer Steuereinheit (UC) sowie mit einem Taktgeber (CLK) mit einer vordefinierten Taktperiode ($T_{clk}$) verbunden sind, wobei die Wandler (CONV_k)außerdem nacheinander zu einer Wandlerkette verkettet sind, wobei jeder Wandler (CONV_k) konfiguriert ist, um ein internes Synchronisationssignal (internal_sync_k) zu erzeugen, um eine Zeitreferenz für die Datenübertragung durch den Wandler (CONV_k) bereitzustellen, wobei jeder Wandler (CONV_k) Folgendes umfasst:

a) ein erstes Modul (MOD1), das konfiguriert ist zum Empfangen eines Synchronisationssignals (sync_in_k), das von der Steuereinheit (UC) für den ersten Wandler (CONV_1) der Kette oder vom vorhergehenden Wandler (CONV_k-1) für die anderen Wandler der Kette übertragen wird, und zum Übertragen des Synchronisationssignals an einen nachfolgenden Wandler in Form eines sogenannten internen Ausgangssignals (sync_out_k) oder an die Steuereinheit (UC) für den letzten Wandler (CONV_N) der Kette;

- ein zweites Modul (MOD2), das konfiguriert ist zum synchronen Empfangen des vom nachfolgenden Wandler, abgesehen vom letzten Wandler (CONV_N) der Kette, in Form eines sogenannten internen Verifizierungssignals (sync_in_check_k) weitergeleiteten Ausgangssignals;

d) ein drittes Modul (MOD3), das konfiguriert ist zum Bestimmen einer Latenz ($lat_{CONV\_K->CONV\_k+1}$) zwischen dem Wandler (CONV_k) und dem nachfolgenden Wandler(CONV_k+1), durch Zählen der Taktperioden zwischen der Übertragung des internen Ausgangssignals (sync_out_k) und dem Empfang des internen Verifizierungssignals (sync_in_check_k) auf derselben aktiven Taktflanke;

e)wobei die Steuereinheit (UC) ferner konfiguriert ist zum Berechnen einer internen Verschiebung ($\Delta_{CONV\_k}$), die auf das interne Synchronisationssignal (internal_sync_k) jedes Wandlers (CONV_k) anzuwenden ist, wobei die interne Verschiebung ($\Delta_{CONV\_k}$)in Abhängigkeit von mindestens einem Teil der bestimmten Latenzen bestimmt wird,

wobei die Steuereinheit (UC) ferner konfiguriert ist zum Berechnen der internen Verschiebung $\Delta_{CONV\_k}$ des Wandlers der Rangstufe k (k =1, ..., N-1) gemäß der folgenden Gleichung, beginnend mit k=N-1:

$$\Delta_{CONV\_k} = 1/2 * lat_{CONV\_k->CONV\_k+1} + \Delta_{CONV-k+1}$$

worin $lat_{CONV\_k->conv\_k+1}$ der Latenz zwischen dem Wandler der Rangstufe k und dem Wandler der Rangstufe k+1 entspricht,
und worin

$$\Delta_{CONV\_N=0}.$$

**Claims**

1. Method for synchronizing a plurality of analog-to-digital or digital-to-analog converters (CONV_k), the converters (CONV_k) all being connected to a control unit (UC), as well as to a clock (CLK) having a predefined clock period ($T_{clk}$), the converters also being progressively chained together so as to form a chain of converters, each converter (CONV_k) generating an internal synchronization signal (internal_sync_k) configured to provide a time reference for the transmission of the data via the converter (CONV_k), the method comprising, for each converter (CONV_k), the following steps:

a) receiving of a synchronization signal (sync_in_k) transmitted by the control unit (UC) for the first converter (CONV_1) of the chain, or transmitted by the preceding converter (CONV_k-1) for the other converters of the chain, and transmitting of the synchronization signal to a following converter (CONV_k+1) in the form of a so-called internal output signal (sync_out_k), or to the control unit (UC) for the last converter (CONV_N) of the chain; **characterized in that** the method further comprises the following steps:

b) receiving, by the following converter (CONV_k+1), of the internal output signal (sync_out_k), and retransmitting to the converter (CONV_k) of the internal output signal (sync_out_k) in the form of a so-called internal check signal (sync_in_check_k), except for the last converter of the chain (CONV_N);
c) receiving of the internal check signal (Sync in check k) by the converter (CONV_k), except for the last converter of the chain (CONV_N);
d) determining a latency ($lat_{CONV\_K->CONV\_}k+1$) between the converter and the following converter, except for the last converter (CONV_N) of the chain, by counting, over the same clock rising edge, clock periods between the transmitting of the internal output signal (sync_out_k) and the receiving of the internal check signal (sync_in_check_k);
e) calculating of an internal shift ($\Delta_{CONV\ k}$) to be applied to the internal synchronization signal (internal_sync_k) of each converter (CONV_k), the internal shift being determined according to at least one part of the determined latencies, wherein the internal shift $\Delta_{CONV\ k}$ of the converter of tier k (k=1, ..., N-1), is calculated by the following relationship, starting with k=N-1:

$$\Delta_{CONV\_k} = 1/2 * lat_{CONV\_k->CONV\_k+1} + \Delta_{CONV-k+1}$$

Where $lat_{CONV\ k->conv\_k+1}$ corresponds to the latency between the converter of tier k and the converter of tier k+1,
And where

$$\Delta_{CONV\_N=0.}$$

2. Method according to claim 1, wherein each converter detects a metastability of the internal check signal (sync_in_check_k), the metastability corresponding to a simultaneity of the internal check signal (sync_in_check_k) with a clock rising edge, and transmits to the control unit (UC) a signal (flag_k) indicating the metastability or not of the internal check signal (sync_in_check_k), the control unit (UC) then transmitting, in case of metastability of the internal check signal (sync_in_check_k), a new synchronization signal (sync_in_k) to the first converter of the chain (CONV_1).

3. Method according to claim 2, wherein the signal (flag_k) indicating the metastability or not of the internal check signal (sync_in_check_k) is transmitted to the control unit over a synchronous serial data bus (SPI).

4. Method according to one of the preceding claims, wherein each converter (CONV_k) transmits to the control unit (UC) the determined internal shift ($\Delta_{CONV\_K}$).

5. Method according to claims 3 and 4, wherein the determined internal shift ($\Delta_{CONV\_k}$) is transmitted to the control unit (UC).

6. Method according to one of the preceding claims, wherein the synchronization signal (sync_in_k) transmitted by the control unit is one pulse of a duration at least equal to one clock period.

7. Method for synchronously converting a plurality of signals (DATA_k) transmitted by a control unit (UC) respectively to a plurality of analog-to-digital or digital-to-analog converters (CONV_k), **characterized in that** the method for converting implements beforehand the method for synchronizing according to one of the preceding claims.

8. System for synchronizing a plurality of analog-to-digital or digital-to-analog converters (CONV_k), the converters (CONV_k) all being connected to a control unit (UC), as well as to a clock (CLK) having a predefined clock period ($T_{clk}$), the converters (CONV_k) also being progressively chained together so as to form a chain of converters, each converter (CONV_k) being configured to generate an internal synchronization signal (internal_sync_k) so as to provide a time reference for the transmission of the data via the converter (CONV_k), each converter (CONV_k) comprising:

- a first module (MOD1) configured to receive a synchronization signal (sync_in_k) transmitted by the control unit (UC) for the first converter (C0NV_1) of the chain, or transmitted by the preceding converter (CONV_k-1) for the other converters of the chain, and to transmit the synchronization signal to a following converter in the form of a so-called internal output signal (sync_out_k), or to the control unit (UC) for the last converter of the chain (CONV_N);

- a second module (MOD2) configured to synchronously receive, except for the last converter (CONV_N) of the chain, the output signal retransmitted by the following converter in the form of a so-called internal check signal (sync_in_check_k);

- a third module (MOD3) configured to determine a latency ($lat_{CONV k->conv\_k+1}$) between the converter (CONV_k) and the following converter (CONV_k+1), by counting, over the same clock rising edge, clock periods between the transmitting of the internal output signal (sync_out_k) and the receiving of the internal check signal (sync_in_check_k);

the control unit (UC) being further configured to calculate an internal shift ($\Delta_{CONV\_k}$) to be applied to the internal synchronization signal (internal_sync_k) of each converter (CONV_k), the internal shift ($\Delta_{CONV\_k}$) being determined according to at least one part of the determined latencies,

wherein the control unit (UC) is configured to calculate the internal shift $\Delta_{CONV k}$ of the converter of tier k (k=1, ..., N-1), by the following relationship, starting with k=N-1:

$$\Delta_{CONV\_k} = 1/2 * lat_{CONV\_k->CONV\_k+1} + \Delta_{CONV-k+1}$$

Where $lat_{CONV k->conv\_k+1}$ corresponds to the latency between the converter of tier k and the converter of tier k+1,

And where

$$\Delta_{CONV\_N=0.}$$

```
┌─────────────────────────────┐
│             a)              │
└─────────────────────────────┘
              │
              ▼
┌─────────────────────────────┐
│             b)              │
└─────────────────────────────┘
              │
              ▼
┌─────────────────────────────┐
│             c)              │
└─────────────────────────────┘
              │
              ▼
┌─────────────────────────────┐
│             d)              │
└─────────────────────────────┘
              │
              ▼
┌─────────────────────────────┐
│             e)              │
└─────────────────────────────┘
```

FIG. 1

FIG. 2

EP 4 162 610 B1

FIG. 3

FIG. 4

sync_in_k

CLK

MOD1 → MOD3 ← MOD2

$lat_{CONV\_k\text{->}CONV\_k+1}$

Sync_out_k

sync_in_check_k

FIG. 5

## RÉFÉRENCES CITÉES DANS LA DESCRIPTION

**Documents brevets cités dans la description**

- EP 3375092 A1
- EP 2658129 A2

- US 2019360911 A1

**Littérature non-brevet citée dans la description**

- A novel method to synchronize high-speed data converters. **STACKLER MARC et al.** 2016 IEEE RADAR CONFERENCE (RADARCONF). IEEE, 02 May 2016, 1-5

- Scalability analysis of the white-rabbit technology for cascade-chain networks. **TORRES-GONZALEZ FELIPE et al.** 2016 IEEE INTERNATIONAL SYMPOSIUM ON PRECISION CLOCK SYNCHRONIZATION FOR MEASUREMENT, CONTROL, AND COMMUNICATION (ISPCS). IEEE, 04 September 2016